# EUROPÄISCHE PATENTSCHRIFT

(11) **EP 2 954 764 B1**
(45) Veröffentlichungstag und Bekanntmachung des Hinweises auf die Patenterteilung: **27.03.2019**
(21) Anmeldenummer: 14716776.1
(22) Anmeldetag: 28.03.2014
(51) Int. Cl.: H05K 3/14, H05K 3/00, B29C 45/00, B29C 45/14, C23C 4/02, C23C 4/08, C23C 4/134, C23C 4/18, H05K 1/02, B29C 45/16, B29L 31/34

(54) **BAUTEIL MIT STRUKTURIERTER OBERFLÄCHE UND VERFAHREN ZU DESSEN HERSTELLUNG**
COMPONENT HAVING A STRUCTURED SURFACE AND METHOD FOR THE PRODUCTION THEREOF
ELEMENT A SURFACE STRUCTUREE ET PROCEDE DE PRODUCTION DE CELUI-CI

(30) Priorität: 16.04.2013 DE 102013103805
(43) Veröffentlichungstag der Anmeldung: 16.12.2015
(73) Patentinhaber: Plasma Innovations GmbH, 4800 Attnang-Puchheim (AT); Pôle Européen de Plasturgie, 01100 Bellignat (FR)
(72) Erfinder: BISGES, Michael, 93049 Regensburg (DE); VEILLE, Amaury, F-01100 Oyonnax (FR); MOGUEDET, Mael, F-01100 Oyonnax (FR); GIROUD, Alexandre, F-01160 Priay (FR)
(74) Vertreter: Kohlmann, Kai
(86) Internationale Anmeldenummer: PCT/EP2014/056337
(87) Internationale Veröffentlichungsnummer: WO 2014/170117

(56) Entgegenhaltungen:
- JP-A- S63 157 850
- US-A- 4 940 623
- US-A1- 2002 139 472
- US-B1- 6 640 434

## Beschreibung

Die Erfindung betrifft ein Verfahren zur Herstellung eines MID-Bauteils mit einer strukturierten Oberfläche und einer Beschichtung auf Bereichen der strukturierten Oberfläche sowie ein nach dem Verfahren herstellbares MID-Bauteil.

Als Molded Interconnect Devices (englisch für: Spritzgegossene Schaltungsträger), kurz MID, werden Bauteile bezeichnet, bei denen elektrische und mechanische Funktionen in ein Spritzgußteil integriert werden. Wesentliche Einsatzgebiete für die MID-Technik sind der Automobilbau, die Industrieautomatisierung, die Medizintechnik, die Hausgeräteindustrie, die Telekommunikationstechnik, die Mess- und Analysetechnik sowie die Luft- und Raumfahrt. Die Vorteile der MID-Technik liegen sowohl in der verbesserten Gestaltungsfreiheit und Umweltverträglichkeit, als auch in einem wirtschaftlichen Herstellungsprozess.

Aus der DE 10 2008 011 249 A1 ist es bereits bekannt, mittels Plasmabeschichtung Beschichtungen auf einer durch Maskierung strukturierten Oberfläche von Substraten abzuscheiden. Die Plasmabeschichtung wird meist dazu benutzt, Beschichtungen mit Schichtdicken von weit mehr als 30 µm abzuscheiden. Bei der Plasmabeschichtung liegt eine Besonderheit darin, dass das im Plasma erhitzte Beschichtungsmaterial, wie Pulver oder Aerosol, großflächig aus der Düse austritt und gleichzeitig auch als verdampftes Material (Nanopartikel) vorliegen kann.

Sofern eine gedruckte Maske auf dem Substrat zum Einsatz gelangt, wird anschließend das Substrat einschließlich der Maske vollflächig beschichtet. Das Ablösen der vollflächig beschichteten Maske ist nur mit erheblichen Schwierigkeiten möglich.

Sofern Schablonen aus biegeschlaffen Materialien als Maskierung zum Einsatz gelangen, bereitet es Probleme, die Maskierungskanten mit einer definierten Anpresskraft vorzuspannen. Durch den Strömungsdruck unterwandert das im Wege der Plasmabeschichtung abgeschiedene Beschichtungsmaterial die Schablone am Rand, allein schon verursacht durch die Oberflächenrauhigkeit des Substrats.

Schließlich sind die von der Leiterplattenherstellung bekannten Photoresist - Verfahren bekannt, bei denen ein Photoresist-Lack vollflächig auf ein Substrat aufgedruckt und anschließend teilweise mit einer Schablone abgedeckt wird. Die nicht abgedeckten Bereiche des Photoresist-Lacks werden mittels UV-Strahlung belichtet und ausgehärtet. Anschließend kann eine dünne Metallisierung auf die ausgehärteten Bereiche, z. B. im Wege des Sputterns, aufgebracht werden. Die von der Schablone abgedeckten und nicht ausgehärteten Bereiche des Photoresist-Lacks werden anschließend entfernt, beispielsweise mit nasschemischen Verfahren.

Die im Stand der Technik bekannten Maskierungstechniken, insbesondere die Verwendung von Schablonen, stehen einem kontinuierlichen Herstellungsprozess von teilweise beschichteten Bauteilen mit einer strukturierten Oberfläche entgegen.

Das Photoresist - Verfahren eignet sich lediglich für die Herstellung von sehr dünnen, meist wenige µm dicken metallischen Beschichtungen, da der nicht gehärtete Photoresist-Lack anschließend nasschemisch entfernt werden muss. Liegt die Beschichtung auf dem nicht ausgehärteten Photoresist-Lack hingegen in einer großen Schichtdicke vor, kann die Chemie nicht mehr durch die Beschichtung auf den Photoresist zugreifen.

Aus der DE 10 2005 062 271 B3 ist ein Verfahren zur Herstellung eines Bauteils mit Leiterbahnen auf der Oberfläche des Bauteils bekannt. Um die Leiterbahnen im Wege des thermischen Spritzens aufzubringen, wird vor dem Spritzen die Oberfläche des Bauteils mit einem Laser derart strukturiert, dass sich ein nicht haftender Bereich mit einer noppenartigen Oberflächenstruktur ausbildet. In diesem Bereich haftet das vorzugsweise im Wege des Flammspritzens aufgebrachte Beschichtungsmaterial zur Ausbildung der Leiterbahnen nicht an der Oberfläche des Bauteils an. Beim thermischen Spritzen wird das Beschichtungsmaterial aufgeschmolzen, in einem Gasstrom beschleunigt und auf die Oberfläche des Bauteils geschleudert. Beim Auftreffen auf das Substrat flachen die Partikel des Beschichtungsmaterials ab, und bleiben vorrangig durch mechanische Verklammerung haften und bauen die Beschichtung auf. Als Energieträger für die An- oder Aufschmelzung des Beschichtungsmaterials dient bei dem nach der DE 10 2005 062 271 B3 bevorzugten Flammspritzen eine Brennstoff-Sauerstoff-Flamme. In Abhängigkeit vom verwendeten Brennstoff werden Flammentemperaturen bis ca. 3160 °C (bei Acetylen-Sauerstoff) erreicht.

Nachteilig bei dem Verfahren nach der DE 10 2005 062 271 B3 ist, dass die haftabweisenden Eigenschaften durch eine mechanische Strukturierung von Bereichen der Oberfläche des Bauteils erzeugt werden, dessen Material grundsätzlich über haftvermittelnde Eigenschaften für das metallische Beschichtungsmaterial verfügt, das im Wege des Flammspritzens zur Erzeugung der Leiterbahnen aufgebracht wird. Je nach Material des Bauteils werden durch die mechanische Strukturierung daher nur unzureichende haftabweisende Eigenschaften in dem noppenartig strukturierten Bereich ereicht. Des Weiteren wird die Bauteiloberfläche durch das Flammspritzen thermisch relativ stark belastet. Das Abscheiden von metallischen Beschichtungen auf thermisch empfindlichen Bauteilen, beispielsweise aus Kunststoff, ist daher mit dem aus der DE 10 2005 062 271 B3 bekannten Verfahren problematisch, da die Oberfläche des Bauteils durch die hohen Temperaturen Schaden nehmen kann.

Die US 6 640 434 B1 offenbart ein Verfahren zum Herstellen eines elektrischen Schaltkreises auf der Oberfläche einer Fahrzeugverkleidung. In eine Oberfläche der Fahrzeugverkleidung werden, Vertiefungen mit einem Boden eingebracht, die eine strukturierte Bodenoberfläche aufweisen. Die strukturierte Bodenoberfläche kann während des Formens der Fahrzeugverkleidung oder mit einem separaten Werkzeug hergestellt werden. Auf die Oberfläche der Türverkleidung wird anschließend ein Maskierfilm aufgebracht, der eine haftabweisende Oberseite und eine klebende Unterseite aufweist. Die klebende Unterseite wird auf die Oberfläche der Fahrzeugverkleidung aufgeklebt. Die Teile des Maskierfilms oberhalb der Vertiefungen in der Fahrzeugverkleidung werden anschließend entfernt. Sodann wird auf die nunmehr freiliegenden, strukturierten Bodenflächen der Vertiefungen elektrisch leitendes, metallisches Material im Wege des thermischen Spritzens oder des Plasmaspritzens aufgebracht. Die Oberfläche an der Oberseite des Maskierungsfilms ist haftabweisend für das aufgebrachte elektrisch leitfähige Material, sodass sich dieses ausschließlich auf der strukturierten Bodenoberfläche innerhalb der Vertiefungen abscheidet. Nach dem Aufbringen des elektrisch leitfähigen Materials wird der Maskierungsfilm entfernt.

Die US 2002/0139472 A1 offenbart ein Verfahren zum Herstellen einer elektrischen Schaltung auf einer Oberfläche eines Substrates, insbesondere einer Fahrzeugverkleidung, wobei bei dem Verfahren ein Substrat mit einer Oberfläche bereitgestellt wird. Ein Maskierfilm wird auf die Oberfläche des Substrates platziert. Bereiche des Maskierfilms werden anschließend gezielt entfernt, um ausgewählte Bereiche der Oberfläche des Substrates freizulegen, um ein elektrisches Schaltungsmuster zu bilden. Dann wird ein elektrisch leitfähiges Material auf die ausgewählten freigelegten Bereiche der Oberfläche des Substrates aufgebracht.

Die US 4 940 623 A offenbart eine Platine für elektrische Bauteile sowie ein Verfahren zu deren Herstellung. Auf einem Substrat, beispielsweise in Form einer herkömmlichen Leiterplatte wird in einem ersten Schritt eine Harzschicht umfassend Mikrokugeln und Perlen aufgebracht. Anschließend wird das Schaltbild durch einen dielektrischen Film oder eine Schutzlackschicht mithilfe eines Lasers in die Harzschicht übertragen. Der Laser brennt Gräben durch den dielektrischen Film beziehungsweise die Schutzlackschicht und zerreißt die Haftvermittlerschicht zwischen den Mikrokugeln und Perlen. Nach Übertragung des Schaltbildes wird im Wege des thermischen Spritzens ein leitfähiges Material auf die Oberfläche des Schaltungsträgers aufgebracht, wobei sich die aufgesprühten Partikel in den Gräben mit den gebrochenen und gerissenen Kugeln und Perlen innerhalb der Gräben verbinden, während die Partikel von der im Übrigen glatten Oberfläche des Schaltungsträgers problemlos entfernt werden können.

Der Erfindung liegt die Aufgabe zu Grunde, ein Verfahren zur kontinuierlichen Herstellung eines teilweise beschichteten MID-Bauteils mit einer strukturierten Oberfläche anzugeben. Außerdem soll ein nach dem Verfahren herstellbares MID-Bauteil angegeben werden.

Die im Stand der Technik bekannten Maskierungstechniken, insbesondere die Verwendung von Schablonen, stehen einem kontinuierlichen Herstellungsprozess von teilweise beschichteten MID-Bauteilen mit einer strukturierten Oberfläche entgegen.

Diese Aufgabe wird durch ein Verfahren mit den Merkmalen des Patentanspruches 1 und ein Bauteil mit den Merkmalen des Patentanspruches 2 gelöst. Die Unteransprüche betreffen vorteilhafte Weiterbildungen der Erfindung.

Ein wesentlicher Gedanke der Erfindung besteht darin, das MID-Bauteil als Verbundkörper aus mindestens einem ersten Formkörper mit haftvermittelnden Oberflächeneigenschaften und mindestens einem zweiten Formkörper mit haftabweisenden Oberflächeneigenschaften derart herzustellen, dass Bereiche der Oberfläche des Verbundkörpers für einen nachfolgenden Plasmabeschichtungsprozeß haftvermittelnde Eigenschaften und andere Bereiche der Oberfläche des Verbundkörpers haftabweisende Eigenschaften für das Beschichtungsmaterial aufweisen, wobei die Beschichtung ausschließlich auf Formkörper mit haftvermittelnden Eigenschaften anhafet. Die räumlich voneinander abgegrenzten Formkörper des Verbundkörpers sind untereinander stoffschlüssig verbunden.

Zur Herstellung der strukturierten Oberfläche auf dem MID-Bauteil wird der Verbundkörper aus mindestens einem ersten Formkörper und mindestens einem zweiten Formkörper mittels Mehrkomponentenspritzguss derart hergestellt, dass Teilbereiche der Oberfläche des ersten Formkörpers mit haftvermittelnder Oberfläche frei bleiben. Die Oberfläche des zweiten Formkörpers weist haftabweisende Eigenschaften für das im nachfolgenden Plasmabeschichtungsprozeß aufgebrachte Beschichtungsmaterial auf.

Bei der nachfolgenden, insbesondere vollflächigen Beschichtung der Oberfläche des Verbundkörpers mittels Plasmabeschichtung verbleibt eine haftfeste Beschichtung auf der freien Oberfläche des ersten Formkörpers wohingegen die haftabweisende Oberfläche des zweiten Formkörpers des Verbundkörpers keine haftfeste Verbindung zwischen Beschichtung und Oberfläche zulässt. Durch einen nachfolgenden Reinigungsschritt wird das lose auf der haftabweisenden Oberfläche des zweiten Formkörpers aufliegende Beschichtungsmaterial entfernt, wodurch man das Bauteil mit strukturierter Oberfläche als Ergebnis erhält.

Die Strukturierung der Oberflächenbereiche des Verbundkörpers erfolgt erfindungsgemäß direkt durch den Mehrkomponentenspritzgussprozess, indem in entsprechenden Werkzeugen die beiden Teile des Verbundkörpers mit unterschiedlichen Geometrien, aber unmittelbar in Teilbereichen verbunden, hergestellt werden.

Als haftabweisende Materialien für das zweite Teil mit einer gegen die Plasmabeschichtung haftabweisenden Charakteristik kommen insbesondere folgende Materialien in Betracht:
- Fluorpolymere (z.B. PTFE, FEP, PFA),
- Polyvinylalkohol (PVAL),
- Composite Polymere mit keramischen Partikeln (z.B. PA-Bornitrid).

Bornitridpartikel weisen insbesondere gegen metallische Plasma-Beschichtungsmaterialien eine optimale haftabweisende Charakteristik auf.

Die Herstellung eines Verbundkörpers aus mindestens einem Teil mit haftvermittelnden Oberflächeneigenschaften und mindestens einem Teil mit haftabweisenden Oberflächeneigenschaften erlaubt die Verwendung unterschiedlicher Materialien für die Teile des Verbundkörpers. Zur Erzeugung der haftabweisenden Eigenschaften für die Beschichtung kann ein besonders geeignetes, auf die erfindungsgemäß vorgesehene Plasmabeschichtung abgestimmtes Material für jedes zweite Teil gewählt werden.

Der Beschichtungsprozess wird als Plasmabeschichtungsprozeß ausgeführt:
In einem Plasmaerzeuger sind eine Anode und eine Kathode im Abstand zueinander angeordnet. Durch den Plasmaerzeuger strömt ein Trägergas, das im Wege einer Lichtbogenentladung zwischen Anode und Kathode angeregt wird. In den derart erzeugten Plasmastrom wird das pulverförmige Beschichtungsmaterial in einer Kornverteilung von 100 nm - 120 µm eingedüst, das durch die hohe Plasmatemperatur an - bzw. aufgeschmolzen wird. Als Beschichtungsmaterial können reine Metalle, Legierungen oder Mischungen für die Ausbildung der strukturierten Oberfläche zum Einsatz kommen. Der Plasmastrom reißt die Pulverpartikel mit und schleudert sie auf das zu beschichtende Bauteil, wo sich das Pulver als geschlossene Schicht auf der Oberfläche des Bauteils abscheidet. Die Gasmoleküle kehren bereits nach kürzester Zeit wieder in einen stabilen Zustand zurück und die Plasmatemperatur sinkt bereits nach kurzer Wegstrecke des Plasmastroms wieder ab, so dass die Oberfläche des Bauteils bei Einhaltung des für die Plasmabeschichtung üblichen Abstands des Plasmaerzeugers zur Oberfläche des Bauteils nur geringfügig thermisch belastet wird.

Die Plasmabeschichtung erfolgt vorzugsweise mit einem Atmosphärendruckplasma. Atmosphärendruckplasma bezeichnet ein Plasma, bei welchem der Druck ungefähr dem der umgebenden Atmosphäre - dem sogenannten Normaldruck - entspricht. Im Gegensatz zum Niederdruckplasma oder Hochdruckplasma wird kein Reaktionsgefäß benötigt, das für die Aufrechterhaltung eines zum Atmosphärendruck unterschiedlichen Druckniveaus sorgt.

Für die Bescchichtung von Teilen aus Kunststoff bieten sich Plasmaerzeuger in einem Leistungsbereich von 0,1-5 kW Leistung an.

Das erfindungsgemäße Verfahren erlaubt den Einsatz unfokussierter Plasmaerzeuger für die Durchführung der Plasmabeschichtung mit einem möglichst breiten Plasmastrahl. Typische Strahlbreiten liegen zwischen 1-50 mm.

In einer Ausgestaltung des erfindungsgemäßen Verfahrens ist ein nachfolgender, gezielter Abtrag von Oberflächenbereichen des Verbundkörpers, beispielsweise im Wege der Laserstrukturierung vorgesehen. Hierbei wird eine obere Materialschicht des ersten oder zweiten Teils (haftvermittelnd oder haftabweisend) selektiv abgetragen, so dass in diesem Abtragsbereich die Oberfläche mit der jeweils entgegengesetzten Oberflächeneigenschaft (haftvermittelnd oder haftabweisend) freigelegt wird. Das Laser-Strukturierungsverfahren bietet sich insbesondere für komplexe Geometrien und feine Strukturen <100µm Auflösung an.

Das erfindungsgemäße Bauteil und Verfahren zu seiner Herstellung werden nachfolgend anhand der Figuren beispielhaft näher erläutert. Es zeigen:
- **Figur 1**: ein erfindungsgemäß hergestellstes MID-Bauteil,
- **Figur 2 a)-e)**: eine schematische Darstellung der Schritte zur Herstellung eines erfindungsgemäßen Bauteils,
- **Figur 3**: eine schematische Darstellung der Schritte zur Herstellung eines erfindungsgemäßen Bauteils basierend auf dem Mehrkomponenten-Spritzgussverfahren,
- **Figur 4**: eine schematische Darstellung der Schritte zur Herstellung eines Bauteils mit einem nicht zur Erfindung gehörigen Verfahren mit nachfolgender Laser-Strukturierung des Verbundkörpers sowie
- **Figur 5**: eine schematische Darstellung des Plasmabeschichtungsprozesses.

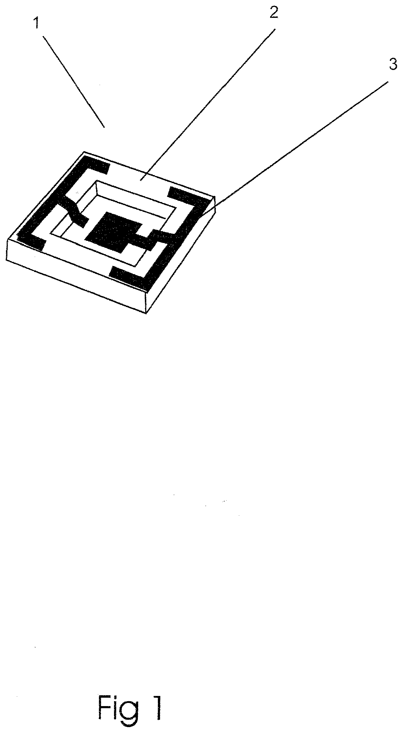

Figur 1 zeigt ein erfindungsgemäßes MID-Bauteil (1) umfassend einen ersten Formkörper (2) mit einer Oberfläche, die haftvermittelnde Eigenschaften aufweist und auf die mittels Plasmabeschichtung eine haftfeste metallische Beschichtung (3) in Form einer Leiterbahnstruktur aufgebracht ist. Die Leiterbahnstruktur umfasst parallel zu den seitlichen Kanten verlaufende Leiterbahnen, die durch eine Vertiefung in der Mitte des Verbundkörpers (2) miteinander verbunden sind.

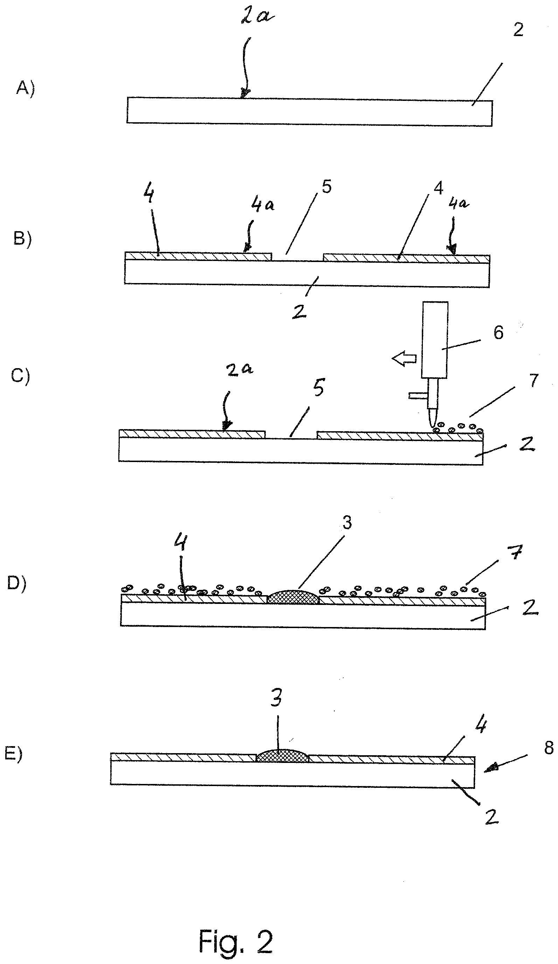

Figur 2 zeigt ein erstes Ausführungsbeispiel eines erfindungsgemäßen Verfahrens zur Herstellung eines Bauteils ausgehend von einem als flächiger erster Formkörper (2) mit haftvermittelnder Oberfläche (2a) ausgeführten ersten Teil eines Verbundkörpers. An die haftvermittelnde Oberfläche (2a) werden im Wege des Spritzgußverfahrens als zweite Teile des Verbundkörpers, zwei zweite Formkörper (4) mit haftabweisenden Oberflächen (4a) angespritzt, wobei ein Bereich (5) der haftvermittelnden Oberfläche (2a) des ersten Formkörpers (2) frei bleibt.

Der in Figur 2b dargestellte Verbundkörper (2, 4) weist an seiner Oberseite nunmehr den freiliegenden Bereich (5) des ersten Teils mit haftvermittelnder Oberfläche (2a) und die beiden nach oben weisenden, haftabweisenden Oberflächen (4a) der zweiten Teile auf.

Aus Figur 2c ist erkennbar, wie in einem anschließenden Verfahrensschritt die Oberseite des Verbundkörpers (2, 4) mit einem atmosphärischen Plasmabeschichtungskopf (6) vollständig mit dem Beschichtungsmaterial (7) beschichtet wird, wobei sich das Beschichtungsmaterial (7) ausschließlich mit der haftvermittelnden Oberfläche (2a) des Formkörpers (2) in dem freien Bereich (5) haftfest verbindet. Die haftende Beschichtung (3) auf der haftvermittelnden Oberfläche (2a) des ersten Formkörpers (2) ist in Figur 2d erkennbar. Lose Partikel des Beschichtungsmaterials (7) auf den haftabweisenden Oberflächen (4a) der zweiten Formkörper (4) werden entfernt, so dass sich das in Figur 2e dargestellte fertige Bauteil (8) mit strukturierter Oberfläche ergibt.

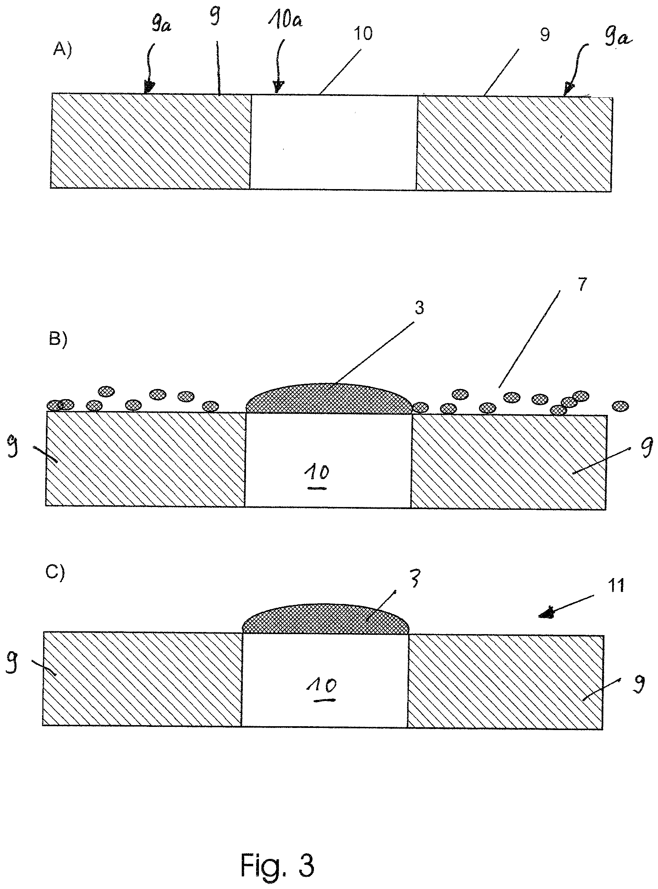

Figur 3 zeigt ein weiteres Ausführungsbeispiel eines erfindungsgemäßen Verfahrens zur Herstellung eines erfindungsgemäßen Bauteils (11) basierend auf dem Mehrkomponentenspritzgussverfahren umfassend einen ersten Formkörper (10) als erstes Teil und zwei zweite Formkörper (9) als zweite Teile, aus denen zunächst ein Verbundkörper hergestellt wird.

Zur Herstellung des Verbundkörpers wird der erste Formkörper (10) mit haftvermittelnder Oberfläche (10a) für das Beschichtungsmaterial (7) als Einlegeteil in einen Mehrkomponenten-Spritzgussprozess für die beiden zweiten Formkörper (9) mit haftabweisenden Oberflächen (9a) eingelegt. Figur 3a zeigt den Verbundkörper (9, 10) nach Abschluss des Mehrkomponentenspritzgussverfahrens Anschließend wird die Oberseite des Verbundkörpers (9, 10) mittels Plasmabeschichtung vollständig mit dem Beschichtungsmaterial (7) beschichtet (Figur 2b), wobei sich das Beschichtungsmaterial (7) ausschließlich mit der haftvermittelnden Oberfläche (10a) an der Oberseite des ersten Formkörpers (10) des Verbundkörpers (9, 10) haftfest verbindet, während die losen Partikel des Beschichtungsmaterials (7) von den haftabweisenden Oberflächen (9a) an der Oberseite der zweiten Formkörper (9) des Verbundkörpers (9, 10) entfernt werden, so dass sich das in Figur 3c dargestellte Bauteil (11) ergibt.

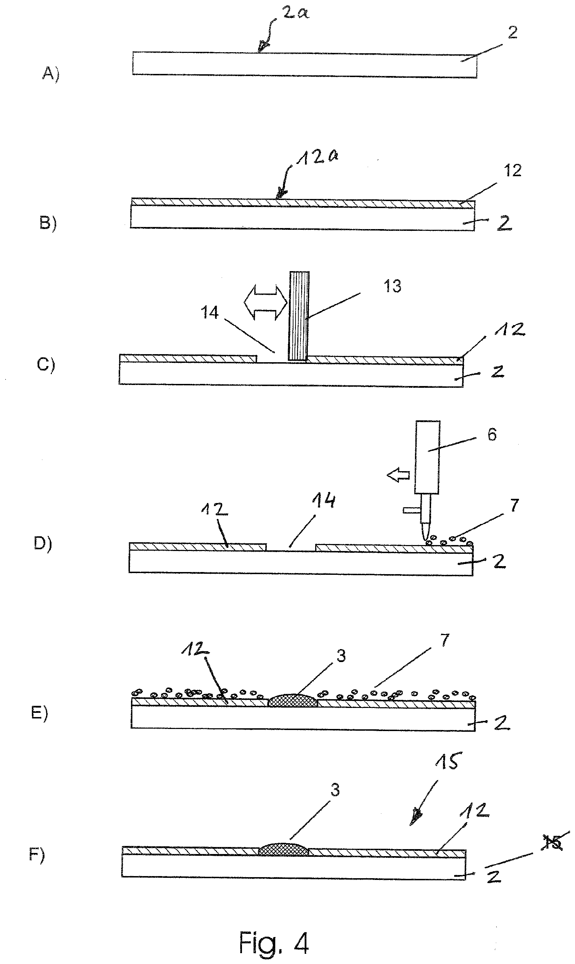

Figur 4 zeigt ein nicht zur Erfindung gehöriges Verfahren, bei dem ein Bauteil (15) im Wege eines kombinierten Beschichtungs- und Abtragsprozesses hergestellt wird.

Auf einen Formkörper (2) mit haftvermittelnder Oberfläche (2a) (vgl. Figur 4a) wird eine Schicht (12) mit haftabweisender Oberfläche (12a) aufgebracht (Figur 2b). Die Schicht (12a) kann ein Lackaufbau oder eine an dem ersten Formkörper (2) anhaftende Folie sein. Sofern es sich um einen Lackaufbau handelt, wird dieser vorzugsweise im Wege eines Sprühprozesses aufgebracht. Die bei der Herstellung des Verbundkörpers (2, 12) vollflächig auf der Oberseite des Formkörpers (2) aufgebrachte Schicht (12) wird anschließend beispielsweise mit Hilfe eines Laserstrahls (13) bereichsweise wieder abgetragen, um die haftvermittelnde Oberfläche (2a) des Formkörpers (2) teilweise wieder freizulegen.

Anschließend wird die Oberseite des Formkörpers (2, 12) vollflächig mit dem atmosphärischen Plasmabeschichtungskopf (6) im Wege der Plasmabeschichtung mit metallischem Beschichtungsmaterial (7) beschichtet. Das Beschichtungsmaterial (7) verbindet sich ausschließlich mit dem zuvor freigelegten Bereich (14) des Formkörpers (2). Die dort anhaftende Beschichtung (3) ist in Figur 4e erkennbar. Die losen Partikel des Beschichtungsmaterials (7) auf der haftabweisenden Oberfläche (12a) der Schicht (12) werden entfernt, so dass sich das fertige, in Figur 4f dargestellte Bauteil (15) ergibt.

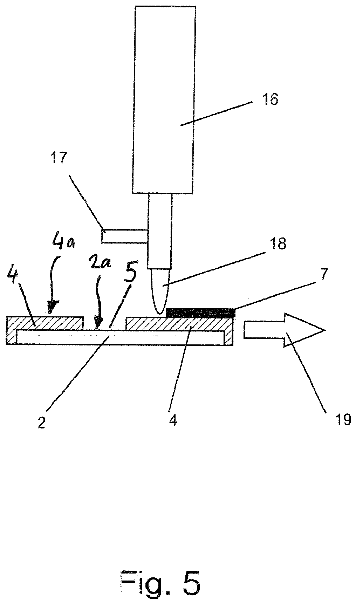

Figur 5 zeigt schematisch den Plasmabeschichtungsprozeß mit einem atmosphärischen Plasmabeschichtungskopf (16) mit einer Einspeisung (17) für das metallische Beschichtungsmaterial (7) in den Plasmastrahl (18). Mit Hilfe des Plasmastrahls (18) wird das Beschichtungsmaterial (7) auf der Oberfläche des Verbundkörpers (2, 4) abgeschieden, wobei das Beschichtungsmaterial (7) sich ausschließlich mit dem ersten Teil (2) des Verbundkörpers mit haftvermittelnder Oberfläche (2a) in dem freien Bereich (5) zwischen den zweiten Teilen (4) mit haftabweisenden Oberflächen (4a) verbindet. Durch ein linienförmiges Abscannen der Oberfläche (4a, 2a) des Verbundkörpers (2,4) können die in und entgegen der Bewegungsrichtung (19) verlaufenden Beschichtungslinien, die eine Einzelbreite zwischen 1 bis 50 mm aufweisen, nahtlos mithilfe des Plasmabeschichtungskopfes (16) aneinandergelegt werden und eine geschlossene Beschichtung auf der Oberseite des Verbundkörpers bilden. Um den Aufwand für das Entfernen des Beschichtungsmaterials (7) von den haftabweisenden Oberflächen (4a) des Verbundkörpers (2, 4) zu reduzieren, steuert der Plasmabeschichtungskopf (16) vorzugsweise nur die freien Bereiche (5) an. Gleichwohl gelangt durch Streuung des breiten Plasmastrahls (18) ein gewisser Anteil des Beschichtungsmaterials (7) auf die haftabweisenden Oberflächen (4a) des Verbundkörpers, so dass der Reinigungsschritt in jedem Fall erforderlich ist.

Das Entfernen des Beschichtungsmaterials von den haftabweisenden Flächen kann mittels an sich bekannter Verfahren der industriellen Teilereinigung erfolgen, beispielsweise im Wege des Bedüsens der Oberfläche mit einem gasförmigen Medium oder eines Waschvorgangs.

In den dargestellten Ausführungsbeispielen bestehen die ersten und zweiten Teile des Verbundkörpers vollständig aus haftvermittelndem bzw. haftabweisendem Material.

Zur Herstellung des Verbundkörpers und dessen Strukturierung kann eine Kombination der vorstehend beschriebenen Spritzguss-, Beschichtungs- und Abtragsverfahren zum Einsatz gelangen.

Jedes zweite Teil mit haftabweisender Oberfläche besteht insbesondere aus einer Fluorpolymerverbindung oder enthält Bornitrid.

Jedes erste Teil mit haftvermittelnder Oberfläche besteht insbesondere aus den Kunststoffen (PA, PC, PPS, LCP).

**Bezugszeichenliste**

| **Nr.** | **Bezeichnung** |
|---|---|
| **Fig. 1** | |
| 1 | Bauteil |

| **Fig. 2** | |
|---|---|
| 2 | Erster Formkörper / erstes Teil |
| 2a | Haftvermittelnde Oberfläche |
| 3 | Beschichtung |
| 4 | Zweiter Formkörper / zweites Teil |
| 4a | Haftabweisende Oberfläche |
| 5 | Freier Bereich |
| 6 | Plasmabeschichtungskopf |
| 7 | Beschichtungsmaterial |
| 8 | Bauteil |

| **Fig. 3** | |
|---|---|
| 9 | Zweiter Formkörper / zweites Teil |
| 9a | Haftabweisende Oberfläche |
| 10 | Erster Formkörper / erstes Teil |
| 10a | Haftvermittelnde Oberfläche |
| 11 | Bauteil |

| **Fig. 4** | |
|---|---|
| 12 | Schicht / zweites Teil |
| 12a | Haftabweisende Oberfläche |
| 13 | Laserstrahl |
| 14 | Freigelegter Bereich |

| **Fig. 5** | |
|---|---|
| 15 | Bauteil |
| 16 | Plasmabeschichtungskopf |
| 17 | Zufuhr Beschichtungsmaterial |
| 18 | Plasmastrahl |
| 19 | Bewegungsrichtung |

## Patentansprüche

1. Verfahren zur Herstellung eines MID-Bauteils (1, 8, 11) mit einer strukturierten Oberfläche und einer Beschichtung (3) auf Bereichen der strukturierten Oberfläche, **dadurch gekennzeichnet, dass**
- zunächst ein Verbundkörper aus mindestens einem ersten Formkörper (2, 10) und mindestens einem zweiten Formkörper (4, 9) mittels Mehrkomponentenspritzguss derart hergestellt wird, dass Teilbereiche der Oberfläche des ersten Formkörpers frei bleiben,
- wobei die Oberfläche jedes ersten Formkörpers (2, 10) haftvermittelnde Eigenschaften für das Beschichtungsmaterial (7) aufweist und jeder erste Formkörper (2, 10) ausschließlich aus einem Material mit haftvermittelnden Eigenschaften für das Beschichtungsmaterial (7) besteht,
- wobei die Oberfläche jedes zweiten Formkörpers (4, 9) haftabweisende Eigenschaften für das Beschichtungsmaterial (7) aufweist und jeder zweite Formkörper (10, 9) ausschließlich aus einem Material mit haftabweisenden Eigenschaften für das Beschichtungsmaterial (7) besteht,
- die Oberfläche jedes ersten Formkörpers (2, 10) und die Oberfläche jedes zweiten Formkörpers (4, 9) mittels eines Plasmabeschichtungsprozesses zumindest teilweise mit dem Beschichtungsmaterial (7) beschichtet werden, wobei sich das Beschichtungsmaterial (7) ausschließlich mit der freien Oberfläche jedes ersten Formkörpers (2, 10) haftfest verbindet
und
- das Beschichtungsmaterial (7) von jedem zweiten Formkörper (4, 9) entfernt wird.

2. MID-Bauteil (1, 8, 11) mit einer strukturierten Oberfläche und einer Beschichtung (3) auf Bereichen der strukturierten Oberfläche herstellbar durch ein Verfahren nach Anspruch 1 umfassend einen Verbundkörper der mindestens einen ersten Formkörper (2, 10) und mindestens einen zweiten Formkörper (4, 9) umfasst, wobei
- die Oberfläche jedes ersten Formkörpers (2, 10) des Verbundkörpers haftvermittelnde und die Oberfläche jedes zweiten Formkörpers (4, 9) des Verbundkörpers haftabweisende Eigenschaften für ein Beschichtungsmaterial (7) aufweist,
- jeder erste Formkörper (2, 10) ausschließlich aus einem Material mit haftvermittelnden Eigenschaften für das Beschichtungsmaterial (7) und jeder zweite Formkörper (4, 9) ausschließlich aus einem Material mit haftabweisenden Eigenschaften für das Beschichtungsmaterial (7) besteht,
- jeder zweite Formkörper (4, 9) mit haftabweisenden Oberflächeneigenschaften Bornitrid oder eine Flourpolymerverbindung oder ein Polyvinylalkohol enthält,
- die Oberfläche jedes ersten Formkörpers (2, 10) zumindest teilweise haftfest mit dem Beschichtungsmaterial (7) beschichtet ist
- und die Oberfläche jedes zweiten Formkörpers (4, 9) des Verbundkörpers frei von Beschichtungsmaterial (7) ist.

3. MID-Bauteil (1, 8, 11) nach Anspruch 2, **dadurch gekennzeichnet, dass** jeder erste Formkörper (2, 10) mit haftvermittelnden Oberflächeneigenschaften aus einem Kunststoff aus der Gruppe PA, PC, PPS oder LCP besteht.

4. MID-Bauteil (1, 8, 11) nach Anspruch 2 oder 3, **dadurch gekennzeichnet, dass** die Beschichtung (3) aus einem metallischen Beschichtungsmaterial (7) besteht.

## Claims

1. Method for producing an MID component (1, 8, 11) having a structured surface and a coating (3) on regions of the structured surface, **characterized in that**
- firstly a composite body comprising at least one first moulding (2, 10) and at least one second moulding (4, 9) is produced by means of multicomponent injection moulding in such a manner that subregions of the surface of the first moulding remain free,
- wherein the surface of each first moulding (2, 10) has adhesion-promoting properties for the coating material (7) and each first moulding (2, 10) exclusively consists of a material having adhesion-promoting properties for the coating material (7),
- wherein the surface of each second moulding (4, 9) has adhesive-repelling properties for the coating material (7) and each second moulding (10, 9) exclusively consists of a material having adhesive-repelling properties for the coating material (7),
- the surface of each first moulding (2, 10) and the surface of each second moulding (4, 9) are at least partially coated with the coating material (7) by means of a plasma coating process, wherein the coating material (7) is firmly adhesively bonded exclusively to the free surface of each first moulding (2, 10)
and
- the coating material (7) is removed from each second moulding (4, 9).

2. The MID component (1, 8, 11) having a structured surface and a coating (3) on regions of the structured surface which can be produced by a method according to claim 1 comprising a composite body comprising at least a first moulding (2, 10) and at least a second moulding (4, 9), wherein
- the surface of each first moulding (2, 10) of the composite body has adhesion-promoting properties and the surface of each second moulding (4, 9) of the composite body has adhesive-repelling properties for a coating material (7),
- each first moulding (2, 10) exclusively consists of a material having adhesion-promoting properties for the coating material (7) and each second moulding (4, 9) exclusively consists of a material having adhesive-repelling properties for the coating material (7),
- each second moulding (4, 9) having adhesive-repelling surface properties contains boron nitride or a fluoropolymer compound or a polyvinyl alcohol,
- the surface of each first moulding (2, 10) is coated at least partially in a firmly adhesive manner with the coating material (7)
- and the surface of each second moulding (4, 9) of the composite body is free from coating material (7).

3. The MID component (1, 8, 11) according to claim 2, **characterized in that** each first moulding (2, 10) having adhesive-promoting surface properties consists of a plastic from the group PA, PC, PPS or LCP.

4. The MID component (1, 8, 11) according to claim 2 or 3, **characterized in that** the coating (3) consists of a metallic coating material (7).

## Revendications

1. Procédé destiné à la fabrication d'un composant MID (1, 8, 11) pourvu d'une surface structurée et d'un revêtement (3) sur des zones de la surface structurée, **caractérisé**
- **en ce qu'**on fabrique d'abord par moulage par injection de multi-composants un corps composite constitué d'au moins un premier corps moulé (2, 10) et d'au moins un deuxième corps moulé (4, 9), de telle sorte que des zones partielles de la surface du premier corps moulés restent libres,
- la surface de chaque premier corps moulé (2, 10) faisant preuve de propriétés promotrices d'adhérence pour la matière de revêtement (7) et chaque premier corps moulé (2, 10) étant exclusivement constitué d'une matière à propriétés promotrices d'adhérence pour la matière de revêtement (7),
- la surface de chaque deuxième corps moulé (4, 9) faisant preuve de propriété anti-adhérentes pour la matière de revêtement (7) et chaque deuxième corps moulé (10, 9) étant exclusivement constitué d'une matière à propriétés anti-adhérentes pour la matière de revêtement (7),
- **en ce qu'**à l'aide d'un processus de revêtement plasmatique, on revêt au moins partiellement la surface de chaque premier corps moulé (2, 10) et la surface de chaque deuxième corps moulé (4, 9) avec la matière de revêtement (7), la matière de revêtement (7) se liant exclusivement par adhérence avec la surface libre de chaque premier corps moulé (2, 10)
et
- **en ce qu'**on retire la matière de revêtement (7) de chaque deuxième corps moulé (4, 9).

2. Composant MID (1, 8, 11) pourvu d'une surface structurée et d'un revêtement (3) sur des zones de la surface structurée, susceptible d'être fabriqué par un procédé selon la revendication 1, comprenant un corps composite qui comprend au moins un premier corps moulé (2, 10) et au moins un deuxième corps moulé (4, 9),
- la surface de chaque premier corps moulé (2, 10) du corps composite faisant preuve de propriétés promotrices d'adhérence et la surface de chaque deuxième corps moulé (4, 9) du corps composite faisant preuve de propriétés anti-adhérentes pour la matière de revêtement (7),
- chaque premier corps moulé (2, 10) étant constitué exclusivement d'une matière à propriétés promotrices d'adhérence pour la matière de revêtement (7) et chaque deuxième corps moulé (4, 9) étant constitué exclusivement d'une matière à propriétés anti-adhérentes pour la matière de revêtement (7),
- chaque deuxième corps moulé (4, 9) à propriétés superficielles anti-adhérentes contenant du nitrure de bore ou un composé fluoropolymérique ou un alcool polyvinylique,
- la surface de chaque premier corps moulé (2, 10) étant revêtue de manière au moins partiellement adhérente avec la matière de revêtement (7)
- et la surface de chaque deuxième corps moulé (4, 9) du corps composite étant exempte de matière de revêtement (7).

3. Composant MID (1, 8, 11) selon la revendication 2, **caractérisé en ce que** chaque premier corps moulé (2, 10) à propriétés superficielles promotrices d'adhérence est constitué d'une matière plastique du groupe comprenant le PA, le PC, le PPS ou le LCP.

4. Composant MID (1, 8, 11) selon la revendication 2 ou 3, **caractérisé en ce que** le revêtement (3) est constitué d'une matière de revêtement (7) métallique.
